# EUROPEAN PATENT APPLICATION

(11) **EP 4 646 040 A1**
(43) Date of publication of application: **05.11.2025**
(21) Application number: 22970285.7
(22) Date of filing: 30.12.2022
(51) Int. Cl.: H05K 1/14, H01Q 1/32, H01Q 1/12, H01Q 1/38, H01R 13/59

(54) **FLEXIBLE PRINTED CIRCUIT BOARD AND ANTENNA ASSEMBLY COMPRISING SAME**

(71) Applicant: LG Electronics Inc., Yeongdeungpo-gu Seoul 07336 (KR)
(72) Inventor: KIM, Dongjin, Seoul 06772 (KR); JUNG, Kangjae, Seoul 06772 (KR); JUNG, Byungwoon, Seoul 06772 (KR); LEE, Soyeon, Seoul 06772 (KR); PARK, Byeongyong, Seoul 06772 (KR)
(74) Representative: Vossius & Partner Patentanwälte Rechtsanwälte mbB
(86) International application number: PCT/KR2022/021761
(87) International publication number: WO 2024/143648

(57) **Abstract**

The present disclosure relates to a flexible printed circuit board and an antenna assembly including the same. A flexible printed circuit board according to an embodiment of the present disclosure, which has one surface on which a feeding area and a plurality of ground areas that are electrically separated from the feeding area are disposed, includes: a first board portion connected to an antenna; a second board portion connected to a connector; and a third board portion disposed between the first board portion and the second board portion, wherein a first width of a first feeding area disposed in the first board portion is greater than a second width of a second feeding area disposed in the second board portion, a width of one end of a third feeding area disposed in the third board portion, one end being adjacent to the first board portion, corresponds to the first width, and a width of the other end of the third feeding area, the other end being adjacent to the second board portion, corresponds to the second width.

## Description

### [Technical Field]

The present disclosure relates to a flexible printed circuit board and an antenna assembly including the same, and more particularly, to a flexible printed circuit board electrically connecting an antenna and a connector and an antenna assembly including the same.

### [Background Art]

A vehicle is a means of transporting people or cargo by using kinetic energy. A representative example of a vehicle is a car.

Recently, development of various systems applied to vehicles for the convenience and safety of users has been actively conducted. In particular, the importance of wireless communication system that allows vehicles to communicate wirelessly with other vehicles, surrounding objects, and base stations is increasing. In addition, it is expected that wireless communication systems using a 5G communication technology will be commercialized in the future to provide more diverse services through vehicles.

Conventionally, antennas for performing wireless communication are configured as a separate structure on one side of a vehicle body, or are disposed on the lower portion of the vehicle body or roof. However, if the antenna is configured as a separate structure on one side of the vehicle's body, this can be a disadvantage in terms of design, as the area where the antenna is disposed is distinguished from other areas and stands out from other areas. In addition, when the antenna is disposed on the lower portion of the vehicle body or roof, there is a problem that the efficiency of the antenna is greatly reduced due to the material of the vehicle body or roof.

Meanwhile, considering the design aspect or the efficiency of the antenna, a transparent antenna may be disposed on the glass of the vehicle. For feeding the transparent antenna, conventionally, a method is applied in which an RF cable is soldered to a board connected to the transparent antenna. However, the conventional method has problems such as inconvenient assembly between components related to the transparent antenna and increased volume. In addition, in a case where the transparent antenna operates as a wideband antenna, a method is required to minimize feeding loss to the antenna and maximize the efficiency of the antenna.

### [Disclosure]

### [Technical Problem]

An object of the present disclosure is to solve the above-mentioned problems and other problems.

Another object is to provide a flexible printed circuit board that stably connects an antenna and a connector, and an antenna assembly including the same.

Another object is to provide a flexible printed circuit board that can reduce the feeding loss for an antenna operating in a wideband, and an antenna assembly including the same.

Another object is to provide a flexible printed circuit board that can improve the efficiency of an antenna operating in a wideband, and an antenna assembly including the same.

### [Technical Solution]

In order to achieve the above object, a flexible printed circuit board according to an embodiment of the present disclosure has one surface on which a feeding area and a plurality of ground areas that are electrically separated from the feeding area are disposed.

In addition, the flexible printed circuit board according to an embodiment of the present disclosure may include a first board portion connected to an antenna; a second board portion connected to a connector; and a third board portion disposed between the first board portion and the second board portion.

In addition, according to an embodiment of the present disclosure a first width of a first feeding area disposed in the first board portion is greater than a second width of a second feeding area disposed in the second board portion, a width of one end of a third feeding area disposed in the third board portion, one end being adjacent to the first board portion, corresponds to the first width, and a width of the other end of the third feeding area, the other end being adjacent to the second board portion, corresponds to the second width.

### [Advantageous Effects]

The effects of the flexible printed circuit board and the antenna assembly including the same according to the present disclosure are described as follows.

According to at least one embodiment of the present disclosure, an antenna and a connector can be stably connected.

In addition, according to at least one embodiment of the present disclosure, a feeding loss for an antenna operating in a wideband can be reduced.

In addition, according to at least one embodiment of the present disclosure, the efficiency of an antenna operating in a wideband can be improved.

Further scope of applicability of the present disclosure will become apparent from the following detailed description. However, it should be understood that the detailed description and specific embodiments such as preferred embodiments of the present disclosure are given by way of illustration only, since various changes and modifications within the spirit and scope of the present disclosure may be clearly understood by those skilled in the art.

### [Description of Drawings]

FIG. 1 is a drawing illustrating an exterior of a vehicle, according to an embodiment of the present disclosure.
FIG. 2 and FIG. 3 are drawings for explaining a position where an antenna is disposed, according to an embodiment of the present disclosure.
FIG. 4 is a block diagram for explaining a vehicle, according to an embodiment of the present disclosure.
FIGS. 5 to 19 are drawings for explaining an antenna assembly, according to embodiments of the present disclosure.
FIGS. 20 to 26 are drawings for explaining a flexible printed circuit board included in an antenna assembly, according to embodiments of the present disclosure.

### [Mode for Invention]

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function. Therefore, the "module" and "unit" may be used interchangeably.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

It will be understood that although the terms first, second, etc. may be used herein to describe various elements, these elements should not be limited by these terms. These terms are only used to distinguish one element from another.

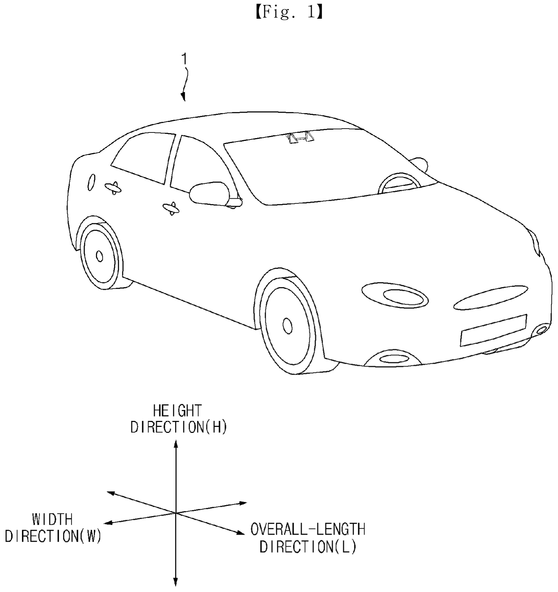

Referring to FIGS. 1 to 3, the overall length refers to the length from the front to the rear of a vehicle 1, the width refers to the width of the vehicle 1, and the height refers to the length from the bottom of a wheel to a roof. In the following description, the overall length direction L may refer to a direction that serves as a reference for measuring the overall length of the vehicle 1, the width direction W may refer to the direction that serves as a reference for measuring the width of the vehicle 1, and the height direction H may refer to the direction that serves as a reference for measuring the height of the vehicle 1.

The vehicle 1 may include at least one antenna for performing communication. For example, the vehicle 1 may include a transmitting antenna for transmitting a signal, a receiving antenna for receiving a signal, and/or a transmitting/receiving antenna for transmitting or receiving a signal. The vehicle 1 may transmit and receive signals of various frequency bands through the antenna. For example, the vehicle 1 may transmit and receive signals such as GPS, 4G wireless communication, 5G wireless communication, Bluetooth, and wireless LAN.

The vehicle 1 may perform communication through an antenna. The vehicle 1 may perform a Vehicle-to-Everything (V2X) communication. The V2X communication may include a Vehicle-to-Vehicle (V2V) which refers to communication between vehicles, a Vehicle to Infrastructure (V2I) which refers to communication between a vehicle and an infrastructure such as base stations (eNBs), and a Road Side Unit (RSU), a Vehicle-to-Pedestrian (V2P) which refers to communication between a user terminal and a vehicle, and a Vehicle-to-Network (V2N) which refers to communication between a vehicle and a network.

The vehicle 1 may include a transparent antenna made of a transparent material. The transparent antenna may be implemented by forming an antenna pattern on a substrate of a transparent material. In the present disclosure, the transparent material substrate is described as being composed of polyethylene terephthalate (PET), but is not limited thereto.

The transparent antenna may be disposed in a dielectric included in the vehicle 1. The transparent antenna may be disposed in an upper area 200a, a lower area 200b, and/or a side area 200c of a windshield 101 of the vehicle 1. The transparent antenna may also be disposed in an upper area 200d and/or a lower area 200e of a rear windshield 102 of the vehicle 1, an area 200f of a quarter glass 103, etc. For example, the vehicle 1 may transmit and receive a signal corresponding to the front direction L, through the transparent antenna disposed in the windshield 101 and/or the rear windshield 102. For example, the vehicle 1 may transmit and receive signals corresponding to the width direction W, through a transparent antenna disposed on the quarter glass 103.

Hereinafter, the vehicle 1 will be described based on the fact that the vehicle performs Sub-6GHz 5G communication using a frequency of 6GHz or less through the transparent antenna.

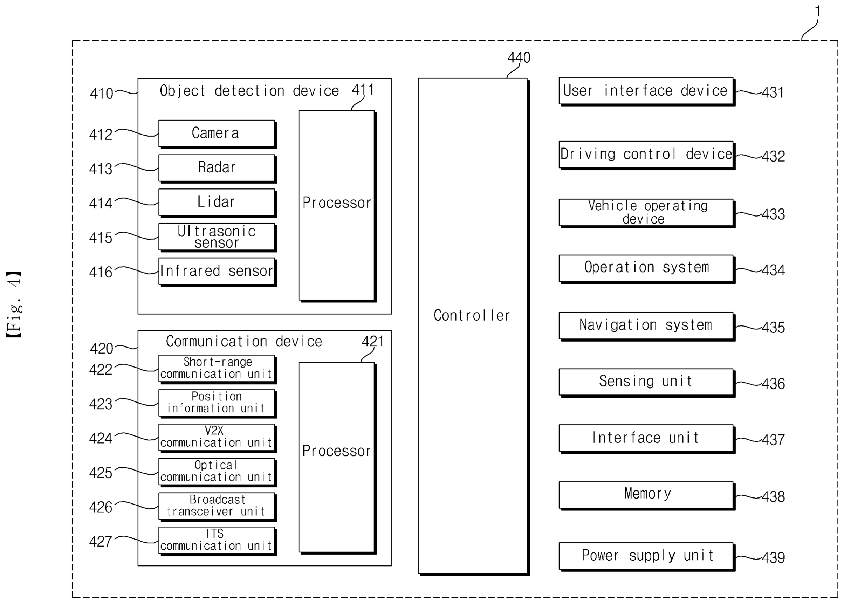

Referring to FIG. 4, the vehicle 1 may include an object detection device 410, a communication device 420, a user interface device 431, a driving control device 432, a vehicle operating device 433, an operation system 434, a navigation system 435, a sensing unit 436, an interface unit 437, a memory 438, a power supply unit 439, and/or a controller 440. Depending on an embodiment, the vehicle 1 may further include other components in addition to the components described herein, or may not include some of the components described.

The object detection device 410 is a device for detecting an object positioned outside the vehicle 1. The object may be various objects related to the operation of the vehicle 1. The object may be classified into a moving object and a stationary object. For example, a moving object may be a concept including a moving other vehicle and a moving pedestrian. For example, the stationary object may be a concept including a traffic signal, a road, a structure, a stationary other vehicle, and a stationary pedestrian.

The object detection device 410 may include a processor 411, a camera 412, a radar 413, a lidar 414, an ultrasonic sensor 415, and/or an infrared sensor 416. Depending on the embodiment, the object detection device 410 may include other components in addition to the components described, or may not include some of the components described.

The processor 411 may control the overall operation of each unit of the object detection device 410. The processor 411 may generate object information, based on data acquired through each unit of the object detection device 410. The object information may include information on the presence or absence of object, position information of object, distance information between the vehicle 1 and an object, and relative speed information between the vehicle 1 and an object.

Depending on the embodiment, the object detection device 410 may include a plurality of processors 411 or may not include a processor 411. For example, the camera 412, the radar 413, the lidar 414, the ultrasonic sensor 415, and/or the infrared sensor 416 may individually include a processor. The object detection device 410 may be operated under the control of the processor or controller 440 of the device inside the vehicle 1.

The communication device 420 is a device for performing communication with an external device. Here, the external device may be another vehicle, a mobile terminal, or a server. To perform communication, the communication device 420 may include at least one of a transmitting antenna, a receiving antenna, an RF element, and a Radio Frequency (RF) circuit capable of implementing various communication protocols.

The communication device 420 may include a processor 421, a short-range communication unit 422, a position information unit 423, a V2X communication unit 424, an optical communication unit 425, a broadcast transceiver unit 426, and/or an ITS communication unit 427. Depending on the embodiment, the communication device 420 may include other components in addition to the components described, or may not include some of the components described.

The processor 421 may control the overall operation of each unit of the communication device 420. The processor 421 may transmit and receive signals through each unit of the communication device 420. Depending on the embodiment, the communication device 420 may include a plurality of processors 421 or may not include a processor 421. If the communication device 420 does not include a processor 421, the communication device 420 may be operated under the control of a processor or a controller 170 of other device in the vehicle 1.

The short-range communication unit 422 is a unit for short-range communication. The short-range communication unit 422 may support short-range communication by using at least one of Bluetooth, Radio Frequency Identification (RFID), Infrared Data Association (IrDA), Ultra-Wideband (UWB), ZigBee, Near Field Communication (NFC), Wireless-Fidelity (Wi-Fi), Wi-Fi Direct, and Wireless Universal Serial Bus (Wireless USB) technologies. The short-range communication unit 422 may form short-range Wireless Area Networks to perform short-range communication between the vehicle 1 and at least one external device.

The position information unit 423 is a unit for obtaining position information of the vehicle 1. For example, the position information unit 423 may include a Global Positioning System (GPS) module or a Differential Global Positioning System (DGPS) module.

The V2X communication unit 424 is a unit for performing V2X communication such as Vehicle-to-Vehicle (V2V), Vehicle to Infrastructure (V2I), Vehicle-to-Pedestrian (V2P), and Vehicle-to-Network (V2N). The V2X communication unit 424 may include an RF circuit capable of implementing protocols for communication with infrastructure (V2I0, communication between vehicles (V2V), communication with pedestrians (V2P), and communication with a network (V2N).

The Intelligent Transport Systems (ITS) communication unit 427 may transmit and/or receive information, data, or signals with a traffic system. For example, the ITS communication unit 427 may receive road traffic information from the traffic system and provide it to the controller 440. For example, the ITS communication unit 427 may receive a control signal from the traffic system, and provide it to the controller 440 or a processor provided inside the vehicle 1.

The user interface device 431 is a device for communication between the vehicle 1 and a user. The user interface device 431 may receive a user input, and provide information generated in the vehicle 1 to a user. The vehicle 1 may implement User Interfaces (UI) or User Experience (UX) through the user interface device 431.

The user interface device 431 may include an input unit that receives a user input from a user, an internal camera that captures images inside the vehicle 1, a biometric detection unit that obtains biometric information such as user's fingerprint information and heartbeat information, an output unit that generates output related to vision, hearing, or touch, a processor, etc. Depending on the embodiment, the user interface device 431 may include additional components in addition to the components described, or may not include some of the components described.

The driving control device 432 is a device that receives a user input for driving. The driving control device 432 may include a steering input device that receives a travel direction input of the vehicle 1 from a user, an acceleration input device that receives an input for acceleration of the vehicle 1 from a user, and/or a brake input device that receives input for deceleration of the vehicle 1 from a user.

The vehicle operating device 433 is a device that electrically controls the operating of various devices inside the vehicle 1. The vehicle operating device 433 may include a power train operating unit, a chassis operating unit, a door/window operating unit, a safety device operating unit, a lamp operating unit, and/or an air conditioning operating unit. Depending on the embodiment, the vehicle operating device 433 may include additional components in addition to the components described, or may not include some of the components described.

The operation system 434 is a system that controls various operations of the vehicle 1. The operation system 434 can be operated in an autonomous driving mode. The operation system 434 may provide a control signal to the vehicle operating device 433. The operation system 434 may include a driving system 710 that controls the driving of the vehicle 1, a parking exit system that controls the parking exit of the vehicle 1, and/or a parking system that controls the parking of the vehicle 1. Depending on the embodiment, the operation system 434 may include other components in addition to the components described, or may not include some of the components described.

The navigation system 435 may provide navigation information. The navigation information may include at least one of map information, set destination information, route information according to the set destination, information on various objects on the route, lane information, and current position information of vehicle. Depending on the embodiment, the navigation system 435 may update previously stored information, based on data received through the communication device 420.

The sensing unit 436 may sense the state of the vehicle. The sensing unit 436 may include an inertial navigation unit (IMU) sensor including an acceleration sensor, a gyro sensor, etc, a collision sensor, a wheel sensor, a speed sensor, a tilt sensor, a weight detection sensor, a heading sensor, a position module, a vehicle forward/rearward sensor, a battery sensor, a fuel sensor, a tire sensor, a steering sensor by steering wheel rotation, a vehicle interior temperature sensor, a vehicle interior humidity sensor, an ultrasonic sensor, an illuminance sensor, an accelerator pedal position sensor, a brake pedal position sensor, and the like. In addition, the sensing unit 436 may further include an accelerator pedal sensor, a pressure sensor, an engine speed sensor, an air flow sensor (AFS), an air temperature sensor (ATS), a water temperature sensor (WTS), a throttle position sensor (TPS), a TDC sensor, a crank angle sensor (CAS), etc.

The interface unit 437 may serve as a passage for various types of external devices connected to the vehicle 1. For example, the interface unit 437 may have a port that can be connected to a mobile terminal. In this case, the interface unit 437 may exchange data with a mobile terminal connected to a port.

The memory 438 is electrically connected to the controller 440. The memory 438 may store basic data for a unit, control data for controlling the operation of a unit, input/output data, etc. The memory 438 may be various storage devices such as a ROM, a RAM, an EPROM, a flash drive, a hard drive, etc. in terms of hardware. The memory 438 may store various data for the overall operation of the vehicle 1, such as a program for processing or controlling the controller 440.

Depending on the embodiment, the memory 438 may be formed integrally with the controller 440, or implemented as a sub-component of the controller 440.

The power supply unit 439 may supply power required for the operation of each component. The power supply unit 439 may receive power from a battery inside the vehicle, etc.

The controller 440 may control the overall operation of each unit inside the vehicle 1. The controller 440 may be named an Electronic Control Unit (ECU).

One or more processors and the controller 440, which are included in the vehicle 1, may be implemented using at least one of application specific integrated circuits (ASICs), digital signal processors (DSPs), digital signal processing devices (DSPDs), programmable logic devices (PLDs), field programmable gate arrays (FPGAs), processors, controllers, micro-controllers, microprocessors, and other electrical units for performing functions.

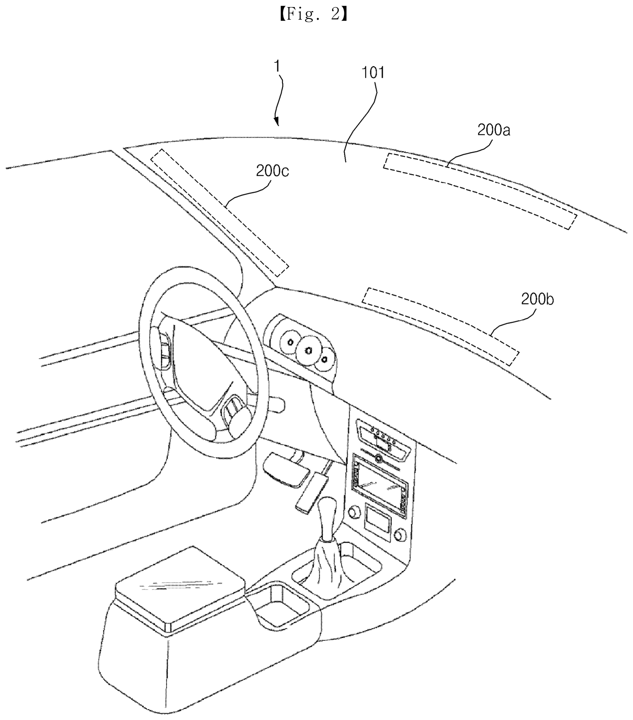

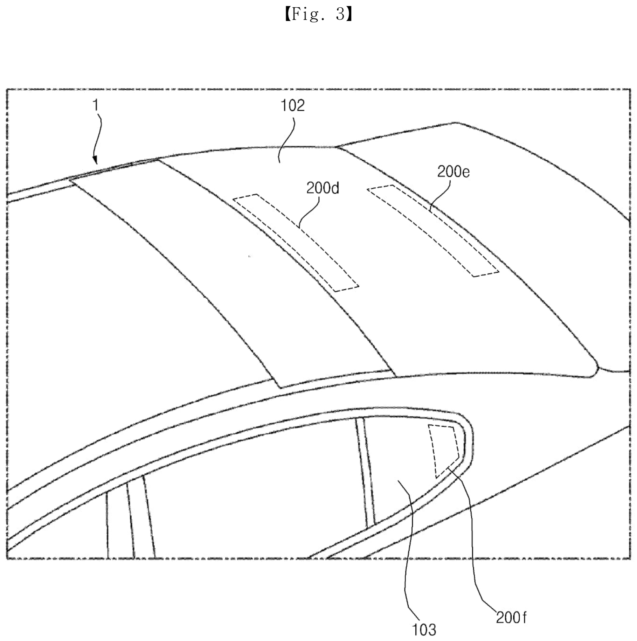

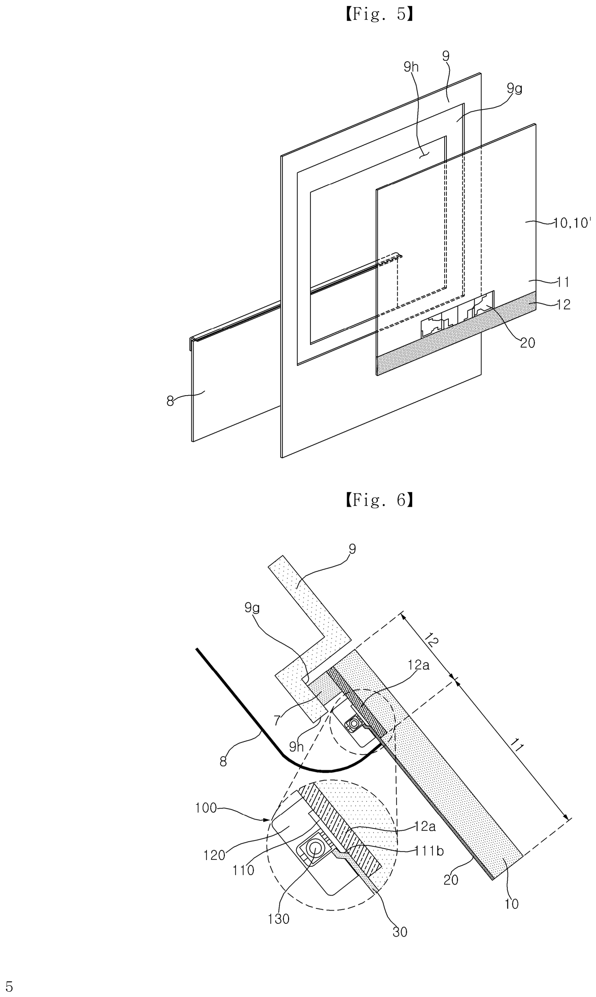

Referring to FIGS. 5 and 6, the glass 10 may be coupled or attached to the frame 9 of the vehicle, and may cover the opening 9h of the frame 9. For example, the glass 10 may be a glass of the vehicle 1, such as a front windshield 101, a rear windshield 102, a quarter glass 103, a door glass, a side mirror, a sunroof, or a lamp glass (see FIGS. 2 and 3). The groove 9g of the frame 9 may extend along the edge of the glass 10, and may define a boundary of the opening 9h. For example, the frame 9 may include a metal material, and a sealant 7 may be filled between the groove 9g and the glass 10.

The antenna 20 may be positioned on one surface of the glass 10. The antenna 20 may be transparent. The antenna 20 may be flexible.

The connection module 100 may be disposed between the edge of the glass 10 and the antenna 20, and may be positioned on the one surface of the glass 10. The connector 130 of the connection module 100 may be electrically connected to the antenna 20 through the board 30. The inner cover 8 may be opposite to the glass 10 with respect to the frame 9, and may cover the connection module 100. The inner cover 8 may be referred to as an interior cover 8. The connection module 100 may be referred to as a connector device 100 or a connector assembly 100.

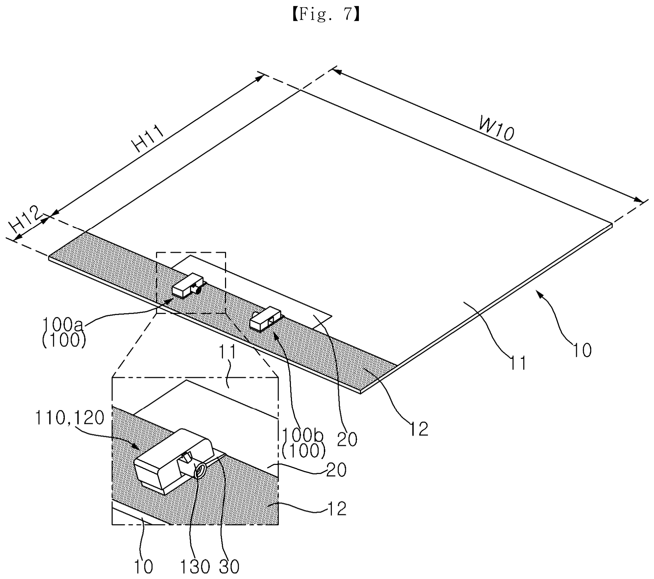

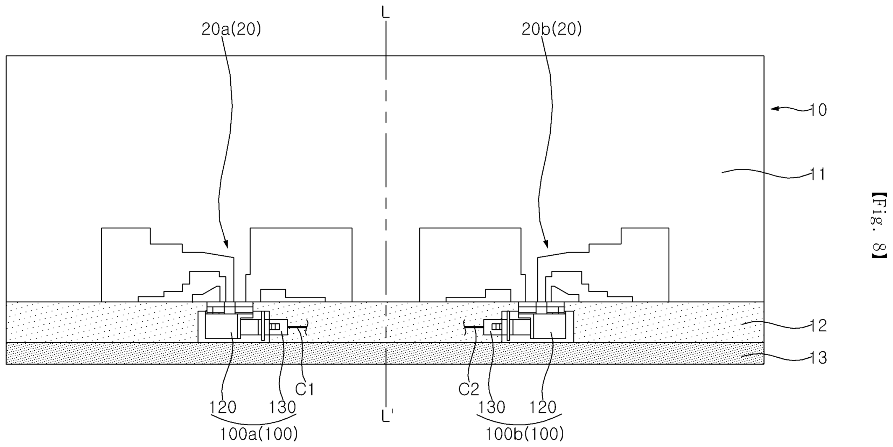

Referring to FIGS. 7 and 8, the glass 10 may include a transparent region 11 and an opaque region 12. The opaque region 12 may be a black masking region or a frit region. For example, the transparent region 11 may occupy most of the glass 10, and the opaque region 12 may be adjacent to one edge of the glass 10. The transparent region 11 and the opaque region 12 may have the same width W10, and the height H11 of the transparent region 11 may be greater than the height H12 of the opaque region 12.

The antenna 20 may be positioned on the transparent region 11 while being adjacent to the boundary between the transparent region 11 and the opaque region 12. The connection module 100 may be positioned on the opaque region 12, and the connector 130 of the connection module 100 may be connected to the antenna 20 through the board 30. Meanwhile, the connection module 100 may also be positioned on the transparent region 11.

N antennas 20 and N connection modules 100 may be positioned on the glass 10 (wherein, n is a natural number greater than or equal to 1). A first antenna 20a may be positioned on the transparent region 11, and may be electrically connected to the first connection module 100a. A second antenna 20b may be next to the first antenna 20a and positioned on the transparent region 11, and may be electrically connected to the second connection module 100b. For example, the first antenna 20a and the second antenna 20b may be symmetrical left and right with respect to a center line LL' of the glass 10. For example, the first connection module 100a and the second connection module 100b may be symmetrical left and right with respect to a center line LL' of the glass 10.

Meanwhile, a packing member 13 made of rubber may be coupled or attached to the opaque region 12 while being adjacent to the connection module 100.

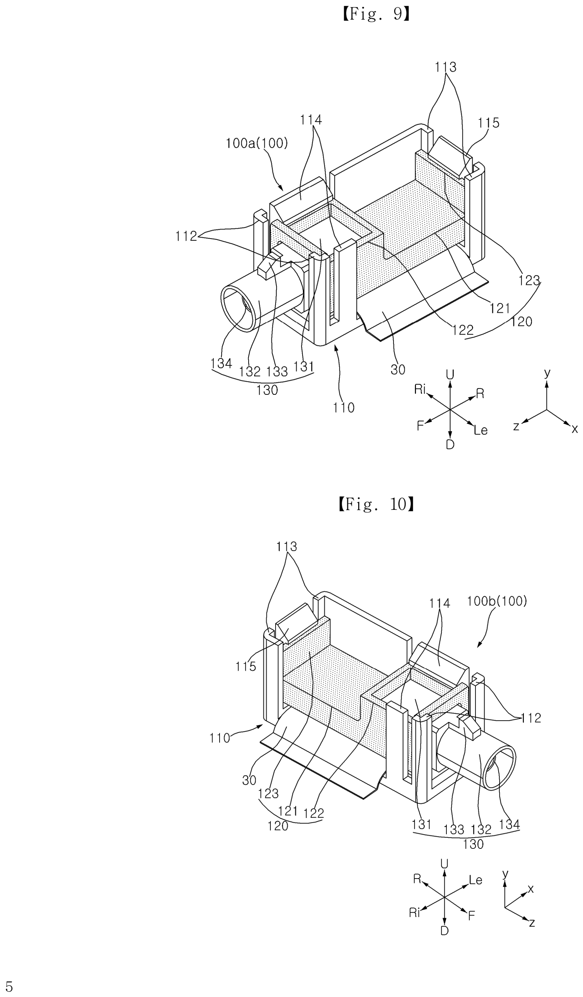

Referring to FIGS. 9 and 10, the direction indications of up U, down D, left Le, right Ri, front F, and rear R shown in the drawing are only for the convenience of explanation, and the technical concept disclosed in the present specification is not limited thereto.

A pair of connection modules 100a, 100b may be symmetrical left and right. That is, the description of the first connection module 100a may be symmetrically applied to the second connection module 100b (vice versa). In addition, a first cable C1 connected to a jack 134 of the connector 130 of the first connection module 100a and a second cable C2 connected to the jack 134 of the connector 130 of the second connection module 100b may be horizontally disposed between the first connection module 100a and the second connection module 100b (see FIGS. 5 and 6). For example, the cables C1, C2 may be detachably coupled to a latch 133 of the connector 130. The cables C1, C2 may be referred to as a coaxial cable or a RF cable.

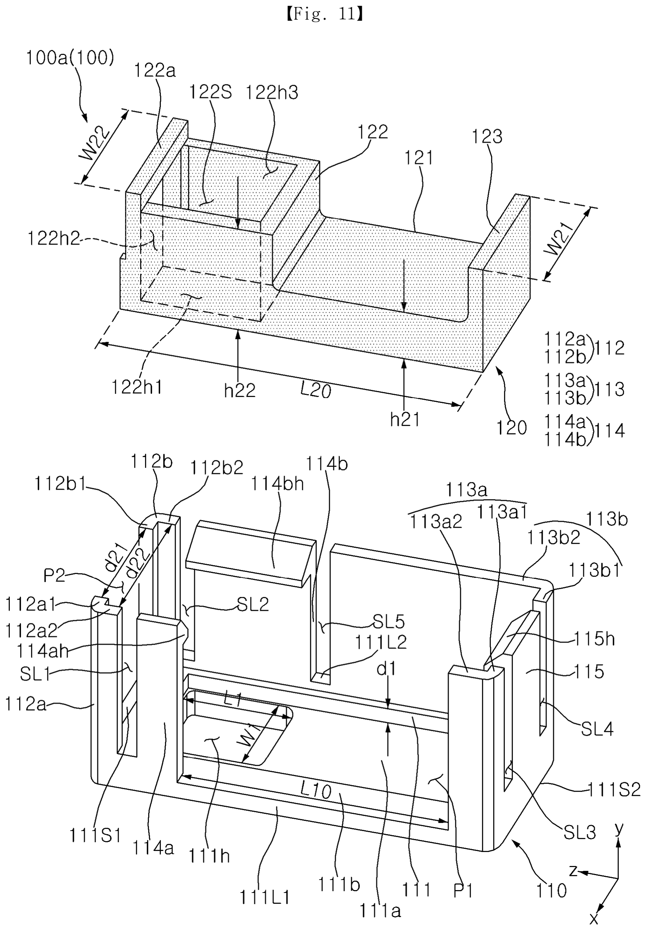

Referring to FIG. 11, the connection module 100 may include a lower housing 110 and an upper housing 120. The lower housing 110 may be referred to as a lower case 110, a bottom housing 110, or a bottom case 110. The upper housing 120 may be referred to as an upper case 120, a top housing 120, or a top case 120. The lower housing 110 and the upper housing 120 may be collectively referred to as a housing 110, 120 or a case 110, 120. For example, the housing 110, 120 may include a plastic material such as Poly Carbonate (PC).

The lower housing 110 may include a base 111 and walls 112, 113, 114, 115. The base 111 may be referred to as a bottom plate 111.

The base 111 may have an overall rectangular plate shape, and may define a bottom of the housing 110, 120. For example, the base 111 may include two long sides 111L1, 111L2 and two short sides 111S1, 111S2. A flat surface portion 111a may be formed on an upper surface of the base 111, and the shape of the flat surface portion 111a may correspond to the shape of the base 111. The hole 111h may be formed by penetrating the flat surface portion 111a in the thickness direction of the base 111. For example, the hole 111h may be a rectangular hole having a certain width W1 and length L1, and may be adjacent to a first short side 111S1.

The walls 112, 113, 114, 115 may protrude from the edges of the base 111 in a direction intersecting with the base 111. For example, the heights of the walls 112, 113, 114, 115 may be equal to or similar to each other.

The front wall 112 may be positioned at a first short side 111S1. The first front wall 112a may protrude upward from the corner where the first short side 111S1 and the first long side 111L1 meet. The first part 112a1 of the first front wall 112a may extend along the first short side 111S1, the second part 112a2 of the first front wall 112a may extend along the first long side 111L1, and the first front wall 112a may have an "L" shaped cross section. The second front wall 112b may protrude upward from a corner where the first short side 111S1 and the second long side 111L2 meet. The first part 112b1 of the second front wall 112b may extend along the first short side 111S1, the second part 112b2 of the second front wall 112b may extend along the second long side 111L2, and the second front wall 112b may have an "L"-shaped cross section. The first front wall 112a and the second front wall 112b may be spaced apart from each other in the length direction of the first short side 111S1, and may be symmetrical with respect to the center of the first short side 111S1. The second distance d22 between the second parts 112a2, 112b2 may be smaller than the first distance d21 between the first parts 112a1, 112b1.

The rear wall 113 may be positioned at the second short side 111S2. The first rear wall 113a may protrude upward from a corner where the second short side 111S2 and the first long side 111L1 meet. The first part 113a1 of the first rear wall 113a may extend along the second short side 111S2, the second part 113a2 of the first rear wall 113a may extend along the first long side 111L1, and the first rear wall 113a may have an "L" shaped cross section. The second rear wall 113b may protrude upward from a corner where the second short side 111S2 and the second long side 111L2 meet. The first part 113b1 of the second rear wall 113b may extend along the second short side 111S2, the second part 113b2 of the second rear wall 113b may extend along the second long side 111L2, and the second rear wall 113b may have an "L" shaped cross section. The first rear wall 113a and the second rear wall 113b may be spaced apart from each other in the length direction of the second short side 111S2, and may be symmetrical with respect to the center of the second short side 111S2. The second distance between the second parts 113a2, 113b2 may be smaller than the first distance between the first parts 113a1, 113b1. For example, the first and second distances may be equal to the first and second distances d21, d22 respectively.

The side wall 114 may be positioned on the long sides 111L1, 111L2. The first side wall 114a may protrude upward from the first long side 111L1, may extend along the first long side 111L1, and may be adjacent to the first short side 111S1. The first side hook 114ah may be formed on the inner surface of the first side wall 114a while being adjacent to the distal end of the first side wall 114a. The second side wall 114b may protrude upward from the second long side 111L2, may extend along the second long side 111L2, and may face the first side wall 114a. The second side hook 114bh may be formed on the inner surface of the second side wall 114b while being adjacent to the distal end of the second side wall 114b.

The central wall 115 may be positioned at the center of the second short side 111S2. The central wall 115 may protrude upward from the second short side 111S2, and may extend along the second short side 111S2. The central hook 115h may be formed on the inner surface of the central wall 115 while being adjacent to the distal end of the central wall 115.

The first opening P1 may be formed between the first rear wall 113a and the first side wall 114a. The second opening P2 may be formed between the first front wall 112a and the second front wall 112b.

The first slit SL1 may be formed between the first front wall 112a and the first side wall 114a. The second slit SL2 may be formed between the second front wall 112b and the second side wall 114b. The third slit SL3 may be formed between the central wall 115 and the first rear wall 113a. The fourth slit SL4 may be formed between the central wall 115 and the second rear wall 113b. The fifth slit SL5 may be formed between the second side wall 114b and the second rear wall 113b. The slits SL1, SL2, SL3, SL4, SL5 may be notches. Accordingly, the side wall 114 and the central wall 115 may be bent or restored from other parts of the lower housing 110.

The upper housing 120 may be positioned above the base 111 of the lower housing 110. The edge of the lower surface of the upper housing 120 may draw a closed shape that is the same as or similar to the boundary of the flat surface portion 111a of the base 111. The upper housing 120 may be positioned between the flat surface portion 111a and the hooks 114ah, 114bh, 115h inside the walls 112, 113, 114, 115 of the lower housing 110. The upper housing 120 may include a cover portion 121, a receiving portion 122, and a hanging portion 123.

The cover portion 121 may have a solid or hollow block shape. The cover portion 121 may face the first area of the flat surface portion 111a, and may be adjacent to the rear wall 113 and the central wall 115. The cover portion 121 may be referred to as a pressurizing portion 121 or a fixing portion 121.

The receiving portion 122 may extend from one end (i.e., the front end) of the cover portion 121 toward the front wall 112, and may face the second area of the flat surface portion 111a. Here, the aforementioned hole 111h may be formed in the second area. The internal space 122S of the receiving portion 122 may be communicated with the hole 111h through the first hole 122h1 formed on one surface (i.e., the lower surface) of the receiving portion 122 facing the hole 111h. The internal space 122S of the receiving portion 122 may be communicated with the second opening P2 through the second hole 122h2 formed on the other surface (i.e., the front surface) of the receiving portion 122 facing the second opening P2. Meanwhile, the upper surface of the receiving portion 122 may be closed or opened through the third hole 122h3.

The hanging portion 123 may protrude from the other end (i.e., the rear end) of the cover portion 121 toward the central hook 115h. At this time, the height h21 of the cover portion 121 may be smaller than the height h22 of the receiving portion 122. Alternatively, the height of the cover portion 121 may be equal to the height h22 of the receiving portion 122, and the hanging portion 123 may be omitted.

The first width W21 of the cover portion 121 described above may be larger than the first distance between the first parts 113a1, 113b1, but may be equal to or smaller than the second distance between the second parts 113a2, 113b2. The second width W22 of the aforementioned receiving portion 122 may be greater than the first distance d21 between the first parts 112a1, 112b1, but may be equal to or smaller than the second distance d22 between the second parts 112a2, 112b2. For example, the second width W22 may be equal to the first width W21.

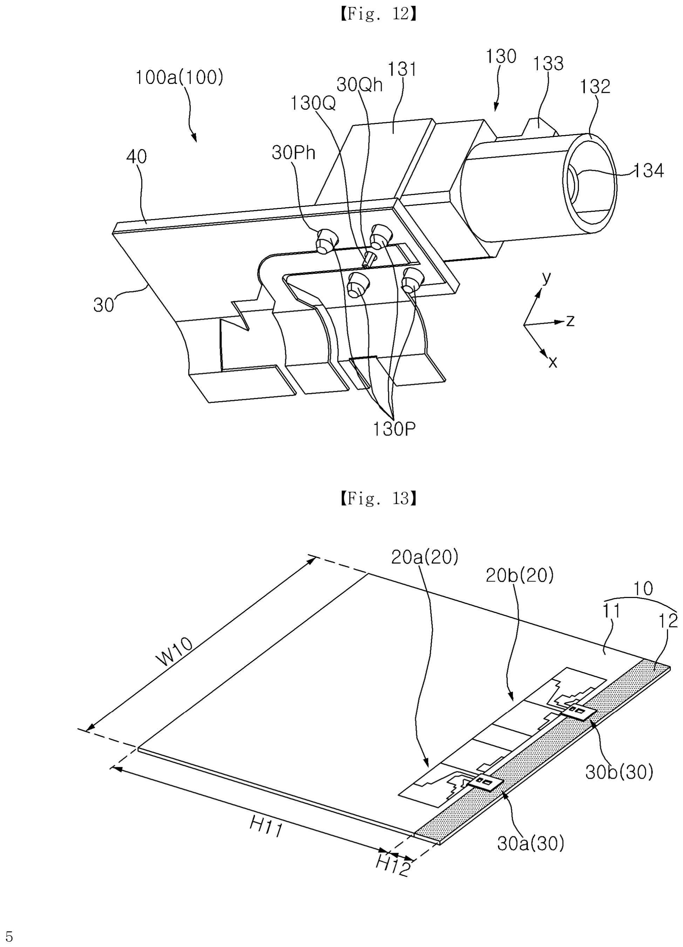

Referring to FIG. 12, the connection module 100 may include a board 30, a plate 40, and a connector 130.

The board 30 may be a printed circuit board PCB. The board 30 may be a flexible printed circuit board (FPCB. In this case, the board 30 may be bent. The board 30 may be referred to as a feeding PCB 30 or a feeding FPCB 30. In the present disclosure, the board 30 is described as being configured as a flexible printed circuit board.

The plate 40 may be positioned on the board 30. For example, the plate 40 may be coupled or attached on the board 30 by an adhesive such as a double-sided tape. The plate 40 may be a dielectric. The plate 40 may include a plastic material such as epoxy. The plate 40 may be thicker than the board 30. The plate 40 may prevent the thin board 30 from warping during a soldering process of the connector 130 and the board 30 described below, and may improve the rigidity of the board 30. The plate 40 may be referred to as a reinforcing plate 40 or a supporting plate 40.

The connector 130 may be opposite to the board 30 with respect to the plate 40. A plurality of ground pins 130P may protrude from one surface (i.e., the lower surface) of the body 131 facing the plate 40, and may penetrate the plate 40 and the board 30. The signal pin 130Q may protrude from the above-mentioned one surface of the body 131, and may penetrate the plate 40 and the board 30. At this time, each of the plate 40 and the board 30 may include holes 30Ph, 30Qh through which the pins 130P, 130Q penetrate. For example, the connector 130 may be an RF connector or a fakra connector.

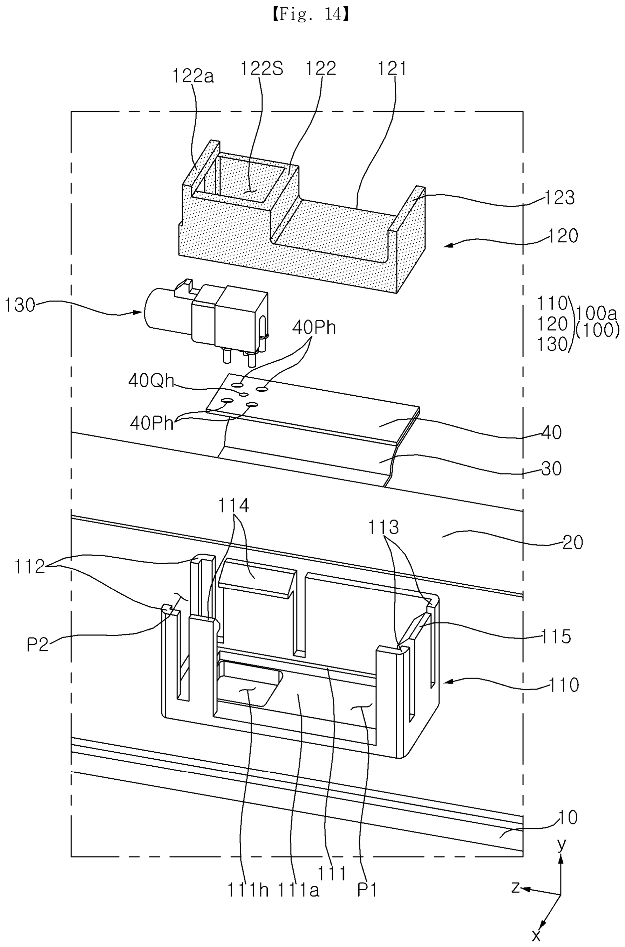

Referring to FIGS. 13 and 14, the antenna 20 and the connection module 100 may be coupled or attached on the glass 10. One end of the board 30 may be electrically connected to the antenna 20, and the connector 130 may be electrically connected to the board 30 by penetrating the holes 40Ph of the plate 40. A portion of the board 30 may be sandwiched between parts of the connection module 100, below the plate 40.

The glass 10, the antenna 20, the board 30, the plate 40, and/or the connection module 100 may be collectively referred to as an antenna assembly, a communication device, or an electronic device.

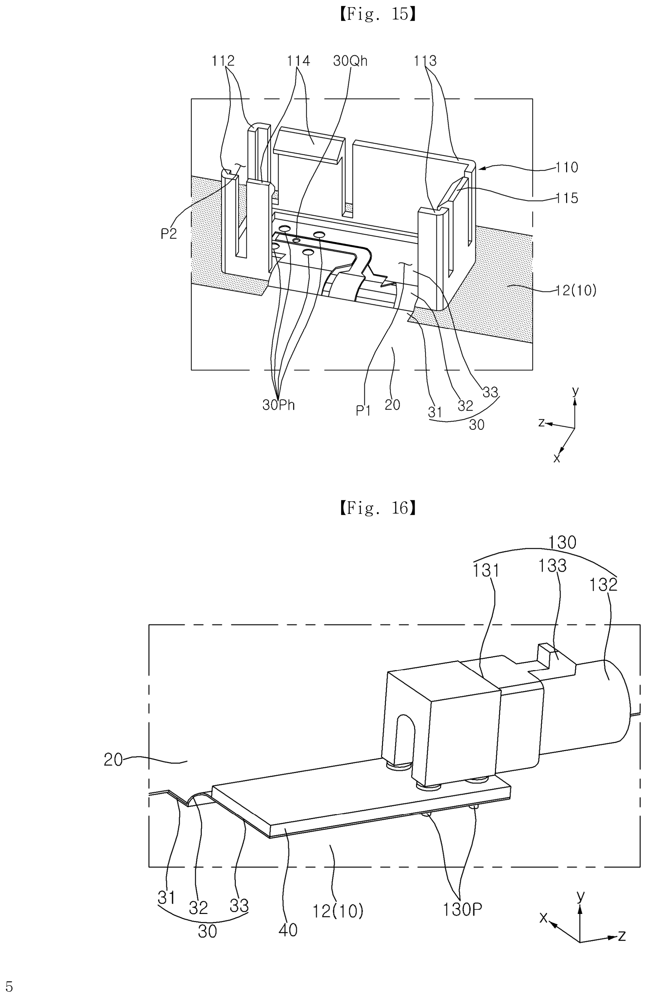

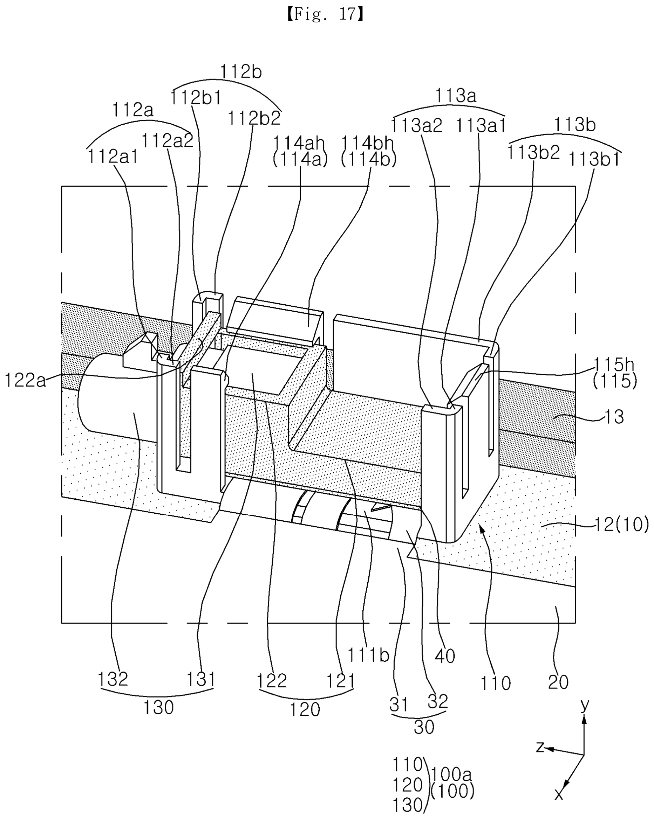

Referring to FIGS. 15 to 17, the antenna 20 may be coupled or attached on the transparent region 11 of the glass 10 through an adhesive such as an Optically Clear Adhesive (OCA) Film. The lower housing 110 may be adjacent to the antenna 20, and may be coupled or attached on the opaque region 12 of the glass 10 through an adhesive such as a double-sided tape.

The board 30 may have one end connected to the antenna 20. A portion of the board 30 may pass through the first opening P1 (see FIG. 14), and be seated on the flat surface portion 111a (see FIG. 14) of the base 111. The plate 40 may be opposite to the flat surface portion 111a of the board 30, and may be coupled or attached to the board 30.

The connector 130 may be opposite to the board 30 with respect to the plate 40, and may be seated on the plate 40 while being adjacent to the front wall 112. The pins 130P, 130Q (see FIG. 12) may penetrate the plate 40 and the board 30 and be soldered to the lower surface of the board 30. The head 132 may extend from the body 131 toward the second opening P2 (see FIG. 14).

The upper housing 120 may be opposite to the plate 40 with respect to the connector 130. The plate 40 may contact the lower surface of the cover portion 121. The body 131 of the connector 130 may pass through the first hole 122h1 (see FIG. 11) of the receiving portion 122 and be received in the internal space 122S (see FIG. 14) of the receiving portion 122. The head 132 of the connector 130 may pass through the second hole 122h2 (see FIG. 11) of the receiving portion 122 and the second opening P2 of the lower housing 110. In addition, the stopper 122a may define a part of the boundary of the second hole 122h2 as a part of the receiving portion 122, and one side of the connector 130 may be caught by the lower end of the stopper 122a.

At this time, the front end of the upper housing 120 may be defined by the receiving portion 122, and may be caught by the rear end of the first parts 112a1, 112b1. The rear end of the upper housing 120 may be defined by the cover portion 121, and may be caught by the front end of the first parts 113a1, 113b1. That is, the lower housing 110 may restrict the forward/rearward movement of the upper housing 120 positioned inside the lower housing 110.

In addition, the left surface of the upper housing 120 may be caught by the inner surface of the second parts 112a2, 113a2 and the first side wall 114a. The right surface of the upper housing 120 may be caught by the inner surface of the second parts 112b2, 113b2 and the second side wall 114b. That is, the lower housing 110 may restrict the left-right movement of the upper housing 120 positioned inside the lower housing 110.

In addition, the upper end of the receiving portion 122 may be caught by the lower end of the side hooks 114ah, 114bh. The upper end of the hanging portion 123 (see FIG. 14) may be caught by the lower end of the central hook 115h. That is, the lower housing 110 may restrict the vertical movement of the upper housing 120 positioned inside the lower housing 110.

Accordingly, the board 30, the plate 40, and the connector 130 may be positioned in place without shaking between the lower housing 110 and the upper housing 120.

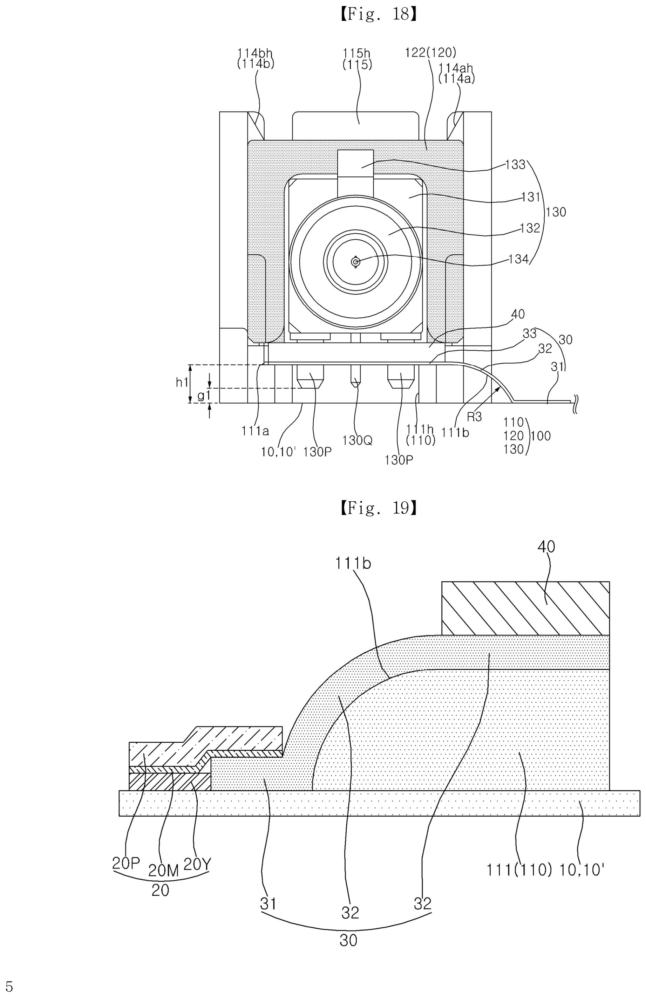

Referring to FIG. 18, the pins 130P, 130Q can protrude from the lower surface of the body 131 of the connector 130 toward the hole 111h of the lower housing 110, and can penetrate the plate 40 and the board 30. The holes 30Ph, 30Qh (see FIGS. 12 and 15) and the hole 111h may be aligned vertically. Here, a portion of the board 30 overlapping with the plate 40 may be referred to as a flat portion 33. A portion of the pins 130P, 130Q may be positioned inside the hole 111h, and may be spaced upward from the upper surface of the glass 10 (see the gap g1 between the pins 130P, 130Q and the glass 10).

Accordingly, the connection module 100 may be disposed flat on the glass 10.

Referring to FIGS. 18 and 19, the board 30 may include a connecting portion 31, a curved portion 32, and a flat portion 33.

At least part of a connecting portion 31 may be positioned on the glass 10. The flat portion 33 may overlap with the plate 40 and may be placed on the flat surface portion 111a. The curved portion 32 may connect the connecting portion 31 and the flat portion 33, and may be positioned on a round portion 111b of the lower housing 110.

The round portion 111b may be a part of the lower housing 110 that connects the first long side 111L1 of the lower housing 110 and the flat surface portion 111a, and may be formed between the first rear wall 113a and the first side wall 114a (see FIG. 11). The length L10 (see FIG. 11) of the round portion 111b may be equal to or greater than the width (defined in the length direction of the round portion 111b) of the curved portion 32. The surface of the round portion 111b may be a curved surface. The surface of the round portion 111b may be a convex surface having a certain radius of curvature R3. Alternatively, the surface of the round portion 111b may be a concave surface having a certain radius of curvature. The curved portion 32 may be bent along the surface of the round portion 111b, and may be seated on the surface of the round portion 111b.

Accordingly, despite the height difference (see h1) between the upper surface of the glass 10 where the connecting portion 31 is positioned and the upper surface of the flat surface portion 111a where the flat portion 33 is positioned, the curved portion 32 may smoothly connect the connecting portion 31 and the flat portion 33. In this case, compared to a case where a straight section is disposed instead of the round portion 111b, damage to the board 30 due to the bending of the board 30 can be minimized.

Meanwhile, the antenna 20 may include a conductive material such as copper, gold, and silver. The antenna 20 may include an antenna pattern in the form of a metal mesh. The metal mesh may be a pattern that implements an electrode by arranging conductive materials such as copper and silver in a grid pattern. The antenna pattern may be configured as a coplanar waveguide (CPW) structure. The CPW structure may be a structure in which a feeding line connected to a radiation pattern and a ground pattern are positioned apart from each other on the same plane.

The antenna 20 may include a first layer 20M in which the metal mesh-shaped antenna pattern is formed, a second layer 20P made of PET material that protects the upper surface of the first layer 20M, and an adhesive member 20Y that is coupled to the lower surface of the first layer 20M and the upper surface of the glass 10.

The board 30 may include a first board layer 30a and/or a second board layer 30b. The first board layer 30a may be formed on the upper surface of the board 30, and the second board layer 30b may be formed on the lower surface of the board 30. The first board layer 30a and the second board layer 30b may be electrically connected through a via. Accordingly, the antenna 20 may be electrically connected to a cable C1, C2 (see FIG. 8) connected to the jack 134 of the connector 130 through the board 30 and pins 130P, 130Q (see FIG. 12). That is, the configuration of the vehicle 1 (see FIG. 1) connected to the cable C1, C2 may perform communication by using the antenna 20.

According to one embodiment, when a signal pin 130Q of the connector 130 penetrating the signal pinhole 30Qh and a ground pin 130P penetrating a ground pinhole 30Ph are connected to the other surface of the board 30 by soldering, the board 30 may include a first board layer 30a and a second board layer 30b. For example, the upper surface of the board 30 may be in contact with the plate 40, and the lower surface of the board 30 may be in contact with the lower housing 110.

According to one embodiment, when the signal pin 130Q of the connector 130 penetrating the signal pinhole 30Qh and the ground pin 130P penetrating the ground pinhole 30Ph are connected to the upper surface of the board 30 in a reflow manner, the board 30 may include a first board layer 30a. For example, the upper surface of the board 30 may be in contact with the connector 130, and the lower surface of the board 30 may be in contact with the plate 40. At this time, the plate 40 may be disposed on the flat surface portion 111a of the lower housing 110.

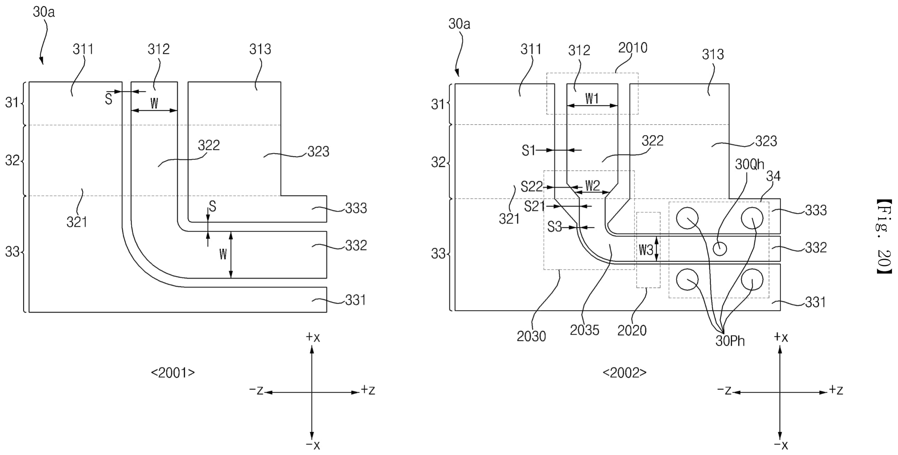

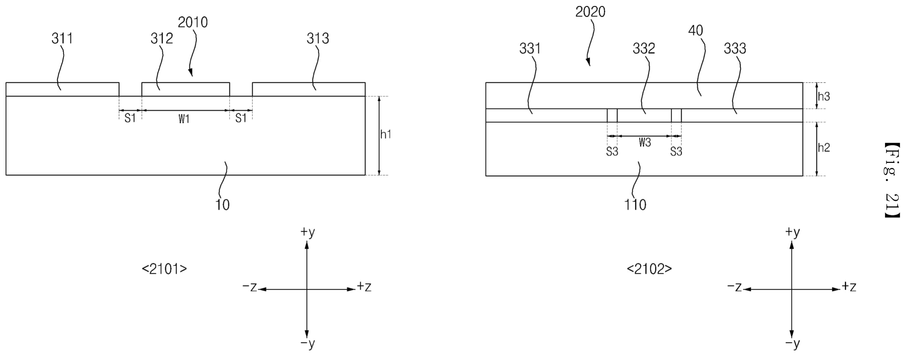

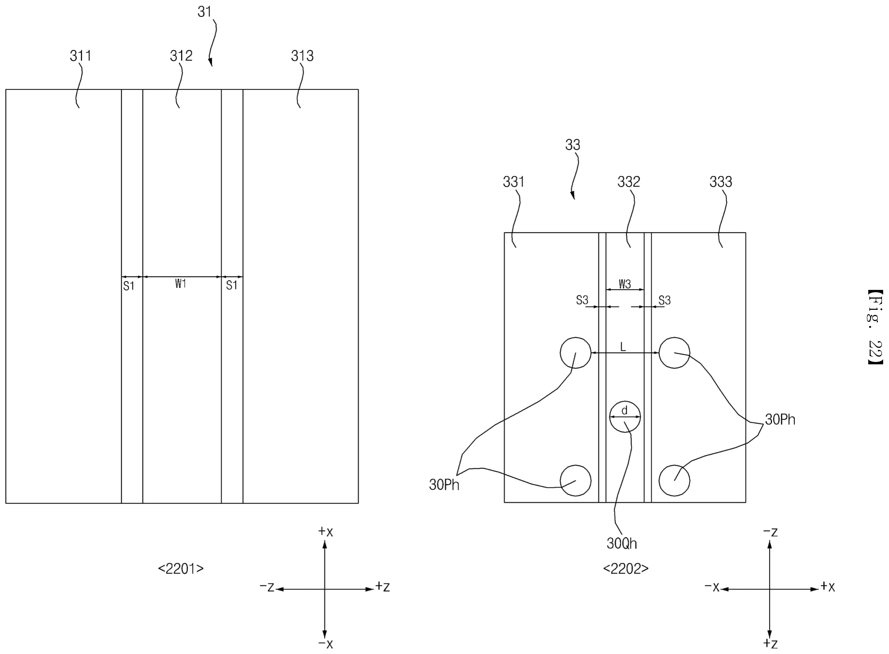

Referring to FIGS. 20 to 22, the first board layer 30a of the board 30 may be configured as a CPW structure. The first board layer 30a may include a feeding area 312, 322, 332, a first ground area 311, 321, 331, and a second ground area 313, 323, 333. The connecting portion 31, the curved portion 32, and the flat portion 33 of the board 30 may be referred to as a board portion.

The feeding area 312 positioned at the connecting portion 31 of the board 30 may be connected to the feeding line of the antenna pattern. Each of the first ground area 311 and the second ground area 311 positioned at the connecting portion 31 of the board 30 may be connected to the ground pattern of the antenna pattern. For example, the feeding area 312, the first ground area 311, and the second ground area 311 positioned at the connecting portion 31 of the board 30 may be connected to the antenna pattern by applying a low-temperature bonding method.

Meanwhile, as shown in the reference numeral 2001, when the width w and the gap s of the feeding areas 312, 322, 332 included in the first board layer 30a of the board 30 are constant, impedance matching between the antenna pattern and the board 30 may not be achieved. For example, the connecting portion 31 may be positioned on the glass 10, and the flat portion 33 may be positioned between the plate 40 and the lower housing 110. In addition, the curved portion 32 may be disposed on the round portion 111b of the lower housing 110, while the flat portion 33 may be disposed on the flat surface portion 111a of the lower housing 110. At this time, the dielectric constant εr, thickness, etc. of the glass 10, the plate 40, and the lower housing 110 may all be different. Therefore, for impedance matching between the antenna pattern and the board 30, the CPW structures for each of the connecting portion 31, the curved portion 32, and the flat portion 33 may be different from each other. In the present disclosure, it will be explained as an example that the antenna impedance of the antenna pattern is 50Ω.

Each of the first width w1 of the feeding area 312 of the connecting portion 31 and the first gap s1 between the feeding area 312 of the connecting portion 31 and the ground area 311, 313 of the connecting portion 31 may have a value corresponding to impedance matching with respect to the antenna pattern.

The connecting portion 31 may have the first width w1 of the feeding area 312 of the connecting portion 31 and the first gap s1 between the feeding area 312 of the connecting portion 31 and the ground area 311, 313, in correspondence with the dielectric constant εr and thickness h1 of the glass 10. For example, if the dielectric constant εr of the glass 10 is 6.5 and the thickness h1 of the glass 10 is 3.5 mm, the first width w1 of the feeding area 312 may be 4 mm, and the first gap s1 between the feeding area 312 and the ground area 311, 313 may be 0.88 mm.

Each of the third width w3 of the feeding area 332 of the third board portion 31 and the third gap s3 between the feeding area 332 and the ground area 331, 333 of the flat portion 33 may have a value corresponding to an impedance matching with respect to the antenna pattern.

The third width w3 of the feeding area 332 of the flat portion 33 may be smaller than the first width w1 of the feeding area 312 of the connecting portion 31 of the board 30. In addition, the third gap s3 between the feeding area 332 of the flat portion 33 and the ground area 331, 333 may be smaller than the first gap s1 between the feeding area 12 of the connecting portion 31 and the ground area 311, 313.

The third width w3 of the feeding area 332 of the flat portion 33 and the third gap s3 between the feeding area 332 of the flat portion 33 and the ground area 331, 333 may correspond to the dielectric constant εr and thickness h2, h3 of the plate 40 and the lower housing 110, respectively. For example, if the dielectric constant εr of the lower housing 110 is 3.5, the thickness h2 of the lower housing 110 is 2.2 mm, the dielectric constant εr of the plate 40 is 4.4, and the thickness h3 of the plate 40 is 1.0 mm, the third width w3 of the feeding area 332 may be 2 mm, and the third gap s3 between the feeding area 332 and the ground area 331, 333 may be 0.27 mm.

One end of the feeding area 322 of the curved portion 32 of the board 30 may be connected to the feeding area 312 of the connecting portion 31. The width of one end of the feeding area 322 of the curved portion 32 may correspond to the first width w1 of the feeding area 312 of the connecting portion 31.

The other end of the feeding area 322 of the curved portion 32 of the board 30 may be connected to the feeding area 332 of the flat portion 33. The width of the other end of the feeding area 322 of the curved portion 32 may correspond to the third width w3 of the feeding area 332 of the flat portion 33.

The second width w2 of at least part of the feeding area 322 of the curved portion 32 of the board 30 may be smaller than the first width w1 of the feeding area 312 of the connecting portion 31 and larger than the third width w3 of the feeding area 332 of the flat portion 33. For example, the second width w2 of at least part of the feeding area 322 of the curved portion 32 may become larger as it approaches the connecting portion 31 along the x-axis direction, and become smaller as it approaches the flat portion 33.

The third width w3 of the feeding area 332 of the third board portion 31 of the board 30 may be larger than the diameter of the signal pinhole 30Qh. The gap L between the ground pinholes 30Ph of the third board portion 31 of the board 30 may be greater than the sum of the third width w3 of the feeding area 332 of the third board portion 31 of the board 30 and the third gap s3 between the feeding area 332 and the ground area 331, 333.

According to one embodiment, the first board layer 30a of the board 30 may include a transition area 2030 that connects the feeding area 312, 322 extending along the x-axis direction with the first width w1 and the feeding area 332 extending along the z-axis direction with the third width w3. The feeding area 2035 included in the transition area 2030 may be formed to be curved so that the feeding area 312, 322 extending along the x-axis direction and the feeding area 332 extending along the z-axis direction are connected.

The gap between the feeding area 2035 included in the transition area 2030 and the ground area 331, 333 may be equal to or greater than the third gap s3.

The gap between a first portion, among the feeding area 2035 included in the transition area 2030, that has the third width w3 and is curvedly extended and the ground area 331, 333 may correspond to the third gap s3.

The gap s21 between the second portion, among the feeding area 2035 included in the transition area 2030, that extends along the x-axis direction with the third width w3 and the ground area 331, 333 may be larger than the third gap s3. The gap s21 between the second portion of the feeding area 2035 included in the transition area 2030 and the ground area 331, 333 may become larger as it approaches the connecting portion 31 along the x-axis direction.

The gap s22 between the third portion, among the feeding area 2035 included in the transition area 2030, that extends along the x-axis direction with the second width w2 and the ground area 321, 323 may be larger than the third gap s3. The gap s22 between the third portion of the feeding area 2035 included in the transition area 2030 and the ground area 331, 333 may become smaller as it approaches the connecting portion 31 along the x-axis direction.

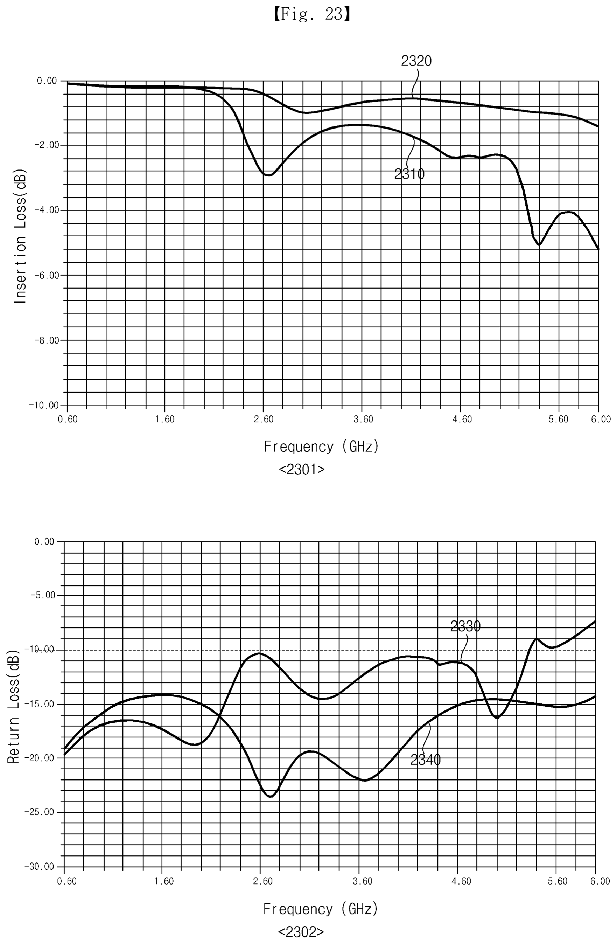

Referring to the reference numeral 2301 of FIG. 23, the insertion loss 2310 in the case where the transition area 2030 is not configured as in the reference numeral 2001 can be compared with the insertion loss 2320 in the case where the transition area 2030 is configured as in the reference numeral 2002. At this time, since the insertion loss 2320 in the case where the transition area 2030 is configured is closer to 0 dB than the insertion loss 2310 in the case where the transition area 2030 is not configured, it can be checked that there is an improvement in terms of insertion loss.

Referring to the reference numeral 2302 of FIG. 23, the reflection loss 2330 in the case where the transition area 2030 is not configured as in the reference numeral 2001 can be compared with the reflection loss 2340 in the case where the transition area 2030 is configured as in the reference numeral 2002. At this time, since the reflection loss 2340 in the case where the transition area 2030 is configured is farther from 0 dB than the reflection loss 2330 in the case where the transition area 2030 is not configured, it can be checked that there is an improvement in terms of the reflection loss as well.

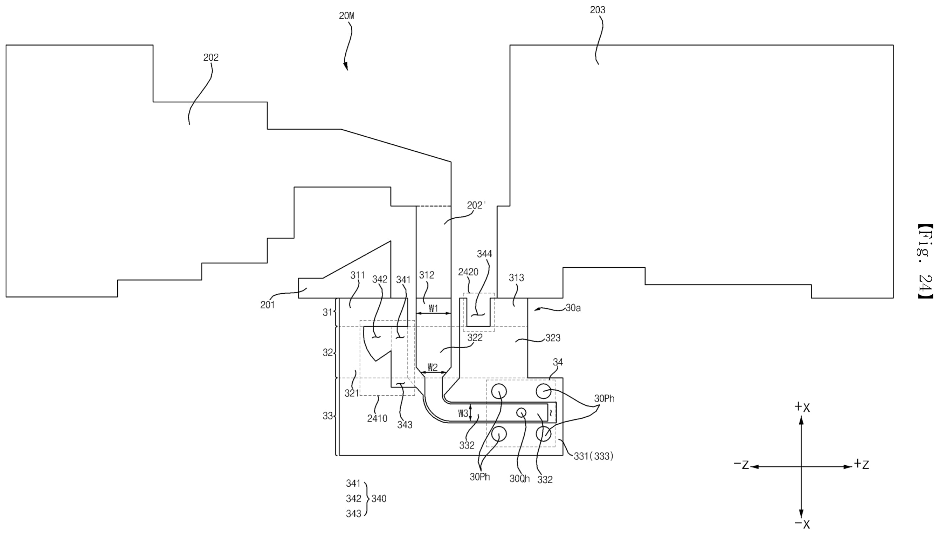

Referring to FIG. 24, the antenna pattern may be configured as a CPW structure including a first ground pattern 201, a radiation pattern 202, a feeding line 202', and a second ground pattern 203. The antenna pattern may be configured as an asymmetrical structure in which the length, width, etc. of the first ground pattern 201 and the second ground pattern 203 are different from each other. In the present disclosure, it will be described as an example in which the length and width of the first ground pattern 201 are smaller than the length and width of the second ground pattern 203. The feeding line 202' may be extended long along the x-axis direction. The radiation pattern 202 may be formed by extending from one end of the feeding line 202' along the -z-axis direction. The radiation pattern 202 and the feeding line 202' may be formed to surround the edge of the first ground pattern 201.

The first ground pattern 201 may be connected to the first ground area 311 of the connecting portion 31. The feeding line 202' may be connected to the feeding area 312 of the connecting portion 31. The second ground pattern 203 may be connected to the second ground area 313 of the connecting portion 31.

According to one embodiment, the first board layer 30a of the board 30 may include a first reduction area 2410 in which the area of the first ground area 311, 321, 331 electrically connected to the first ground pattern 201 is reduced. The first board layer 30a of the board 30 may include a second reduction area 2420 in which the area of the second ground area 313, 323, 333 electrically connected to the second ground pattern 202 is reduced.

The first reduction area 2410 may include a first slit pattern 340 formed by recessing an edge of the first ground area 311, 321, 331 adjacent to the feeding area 312, 322, 332 along the -x-axis direction away from the feeding area 322 332.

The first slit pattern 340 may include a first sub-slit pattern 341 formed by recessing an edge of the first ground area 321 of the curved portion 32 along the -x-axis direction. The first sub-slit pattern 341 may be formed in a square shape.

The first slit pattern 340 may include a second sub-slit pattern 342 formed by additionally recessing the first ground area 321 along the -x-axis direction from a portion of the edge of the first sub-slit pattern 341. The second sub-slit pattern 342 may be formed in a fan shape.

The first slit pattern 340 may include a third sub-slit pattern 343 formed by recessing a portion of the edge of the first ground area 331 of the third board portion 32 along the -x-axis direction. The third sub-slit pattern 343 may be formed in a trapezoidal shape.

The first sub-slit pattern 341, the second sub-slit pattern 342, and the third sub-slit pattern 343 may be connected to each other to form the first slit pattern 340.

The second reduction area 2420 may include a second slit pattern 344 formed by recessing an edge of the second ground area 313 adjacent to the antenna pattern along the -y-axis direction away from the antenna pattern. The second slit pattern 344 may be formed by recessing a part of the edge of the second ground area 313 adjacent to the antenna pattern, which does not come into contact with the second ground pattern 203, along the -x-axis direction. The second slit pattern 344 may be formed in a rectangular shape.

According to one embodiment, the first ground area 331 and the second ground area 333 of the flat portion 33 may be connected to each other. The first ground area 331 and the second ground area 333 connected to each other may be formed to surround the feeding area 332 of the flat portion 33.

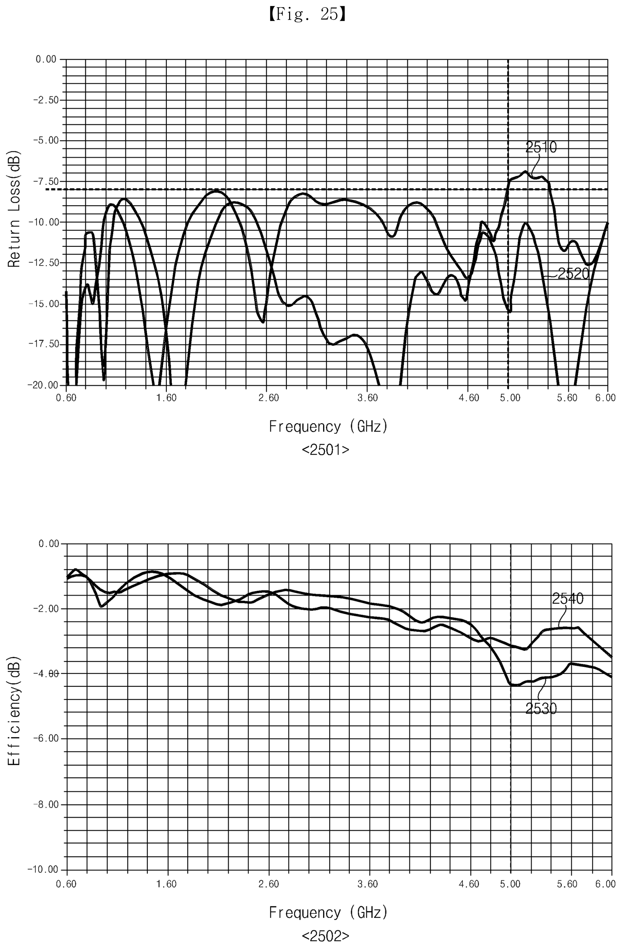

Referring to the reference numeral 2501 of FIG. 25, when the antenna pattern is connected to the board 30, the reflection loss 2510 in the case where the first reduction area 2410 and the second reduction area 2420 are not configured can be compared with the reflection loss 2520 in the case where the first reduction area 2410 and the second reduction area 2420 are configured. At this time, since the reflection loss 2520 in the case where the first reduction area 2410 and the second reduction area 2420 are configured is farther from 0 dB than the reflection loss 2510 in the case where the first reduction area 2410 and the second reduction area 2420 are not configured, it can be checked that there is an improvement in terms of the reflection loss.

Referring to the reference numeral 2502 of FIG. 25, when the antenna pattern is connected to the board 30, the antenna efficiency 2530 in the case where the first reduction area 2410 and the second reduction area 2420 are not configured can be compared with the antenna efficiency 2540 in the case where the first reduction area 2410 and the second reduction area 2420 are configured. Here, the antenna efficiency 2530, 2540 can be expressed in a decibel dB corresponding to the antenna gain. At this time, in the Sub-6GHz that is 5G frequency band, especially, in the frequency band of 5GHz or higher, since the antenna efficiency 2540 in the case where the first reduction area 2410 and the second reduction area 2420 are configured is closer to 0dB than the antenna efficiency 2530 in the case where the first reduction area 2410 and the second reduction area 2420 are not configured, it can be checked that the antenna efficiency is improved.

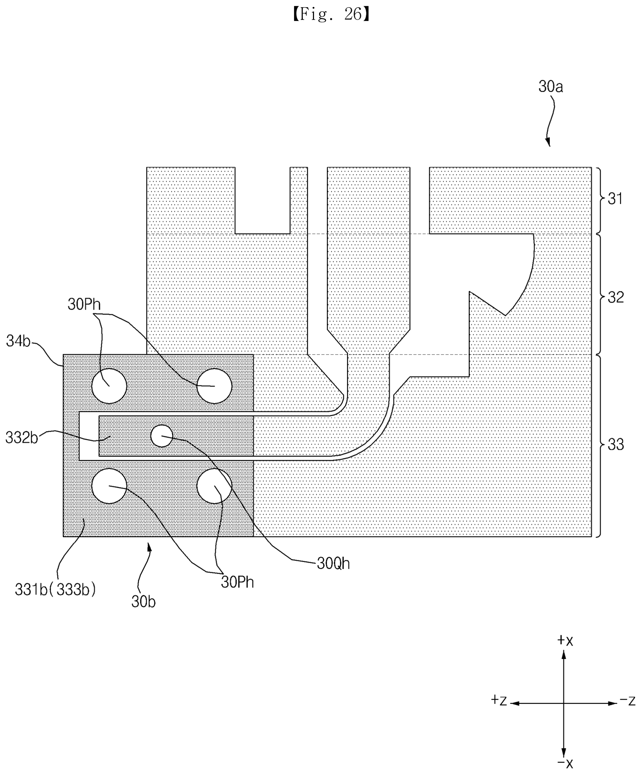

Referring to FIG. 26, the board 30 according to one embodiment may include a second board layer 30b. The second board layer 30b may be formed on the flat portion 33 of the board 30. The second board layer 30b may include a ground area 331b, 333n and a feeding area 332b so as to match the area 34 corresponding to the connector 130 of the first board layer 30a among the flat portion 33.

The ground pin 130P penetrating the ground pinhole 30Ph may be soldered to the ground area 331b, 333n of the second board layer 30b. The signal pin 130Q of the connector 130 penetrating the signal pinhole 30Qh may be soldered to the feeding area 332b of the second board layer 30b.

As described above, according to at least one embodiment of the present disclosure, the antenna 20 and the connector 130 may be electrically connected.

In addition, according to at least one embodiment of the present disclosure, it is possible to reduce the feeding loss for the antenna 20 operating in a wideband.

In addition, according to at least one embodiment of the present disclosure, it is possible to improve the efficiency of the antenna 20 operating in a wideband.

Referring to FIGS. 1 to 26, a flexible printed circuit board according to an aspect of the present disclosure, which has one surface on which a feeding area and a plurality of ground areas that are electrically separated from the feeding area are disposed, includes: a first board portion connected to an antenna; a second board portion connected to a connector; and a third board portion disposed between the first board portion and the second board portion, in which a first width of a first feeding area disposed in the first board portion is greater than a second width of a second feeding area disposed in the second board portion, a width of one end of a third feeding area disposed in the third board portion, one end being adjacent to the first board portion, corresponds to the first width, and a width of the other end of the third feeding area, the other end being adjacent to the second board portion, corresponds to the second width.

In addition, according to an aspect of the present disclosure, a third width of at least part of the third feeding area is smaller than the first width, and is larger than the second width.

In addition, according to an aspect of the present disclosure, the third width increases as it approaches the first board portion.

In addition, according to an aspect of the present disclosure, a first gap between the first feeding area and the plurality of ground areas is larger than a second gap between the second feeding area and the plurality of ground areas.

In addition, according to an aspect of the present disclosure, the first board portion is disposed on glass, the third board portion is disposed between a housing to which the connector is fixed and a plate, and the plate is disposed between the third board portion and the connector.

In addition, according to an aspect of the present disclosure, the housing is disposed on the glass, and at least part of the third board portion is disposed on a round portion of the housing that is stepped from the glass and has a curved surface.

In addition, according to an aspect of the present disclosure, the first width and the first gap correspond to a dielectric constant and thickness of the glass, and the second width and the second gap correspond to the dielectric constant and thickness of the housing and the dielectric constant and thickness of the plate.

In addition, according to an aspect of the present disclosure, a part of the feeding area having the second width includes: a first portion extending along a first direction; a second portion extending along a second direction different from the first direction; and a third portion formed to be curved so that the first portion and the second portion are connected, in which a gap between the first portion and the plurality of ground areas and a gap between the third portion and the plurality of ground areas correspond to a certain gap, and a gap between the second portion and the plurality of ground areas is larger than the certain gap.

In addition, according to an aspect of the present disclosure, the gap between the second portion and the plurality of ground areas increases as it approaches the antenna.

In addition, according to an aspect of the present disclosure, the second board portion includes a signal pinhole through which a signal pin of the connector passes, in which the second width is larger than a diameter of the signal pinhole.

An antenna assembly according to another aspect of the present disclosure includes: an antenna positioned in a first area of glass; a connection module which is positioned in a second area of the glass, and includes a connector; and a flexible printed circuit board which has one surface on which a feeding area and a plurality of ground areas that are electrically separated from the feeding area are disposed, in which the flexible printed circuit board includes: a first board portion connected to the antenna; a second board portion connected to the connector; and a third board portion disposed between the first board portion and the second board portion, in which a first width of a first feeding area disposed in the first board portion is greater than a second width of a second feeding area disposed in the second board portion, a width of one end of a third feeding area disposed in the third board portion, one end being adjacent to the first board portion, corresponds to the first width, and a width of the other end of the third feeding area, the other end being adjacent to the second board portion, corresponds to the second width.

In addition, according to another aspect of the present disclosure, the connection module includes: a lower housing which is coupled on the glass, and on which the second board portion is seated; and an upper housing which is opposite to the lower housing with respect to the board, and coupled to the lower housing, in which the connector is positioned between the board and the upper housing.

In addition, according to another aspect of the present disclosure, the antenna is a transparent antenna, the first area is a transparent region, and the second area is an opaque region.

In addition, according to another aspect of the present disclosure, the lower housing includes a round portion that is stepped from the glass and has a curved surface, and at least part of the third board portion is disposed on the curved surface of the round portion.

In addition, according to another aspect of the present disclosure, the flexible printed circuit board further includes a plate which is positioned between the flexible printed circuit board and the connector, and coupled to the flexible printed circuit board, in which a signal pin of the connector penetrates the plate and the second board portion, and is coupled to the second board portion.

Since the accompanying drawings are merely for easily understanding embodiments disclosed herein, it should be understood that the technical spirit disclosed herein is not limited by the accompanying drawings, and all changes, equivalents or substitutions are included in the spirit and technical scope of the present disclosure.

Meanwhile, a method of operation of the present disclosure can also be embodied as processor readable code on a processor-readable recording medium. The processor-readable recording medium includes all kinds of recording apparatuses storing data that can be read by a processor. Examples of the processor-readable recording medium is ROM, RAM, CD-ROM, magnetic tapes, floppy disks, optical data storage apparatuses, and, including those that are implemented in the form of carrier waves such as data transmission through the Internet. In addition, the processor-readable recording medium is dispersed in computer systems connected through a network, so that the processor-readable code can be stored and executed in a distributed fashion.

Although the present disclosure has been described with reference to specific embodiments shown in the drawings, it is apparent to those skilled in the art that the present description is not limited to those exemplary embodiments and is embodied in many forms without departing from the scope of the present disclosure, which is described in the following claims. These modifications should not be individually understood from the technical spirit or scope of the present disclosure.

## Claims

1. A flexible printed circuit board which has one surface on which a feeding area and a plurality of ground areas that are electrically separated from the feeding area are disposed, the flexible printed circuit board comprising:
a first board portion connected to an antenna;
a second board portion connected to a connector; and
a third board portion disposed between the first board portion and the second board portion,
wherein a first width of a first feeding area disposed in the first board portion is greater than a second width of a second feeding area disposed in the second board portion,
a width of one end of a third feeding area disposed in the third board portion, one end being adjacent to the first board portion, corresponds to the first width, and
a width of the other end of the third feeding area, the other end being adjacent to the second board portion, corresponds to the second width.

2. The flexible printed circuit board of claim 1, wherein a third width of at least part of the third feeding area is smaller than the first width, and is larger than the second width.

3. The flexible printed circuit board of claim 2, wherein the third width increases as it approaches the first board portion.

4. The flexible printed circuit board of claim 1, wherein a first gap between the first feeding area and the plurality of ground areas is larger than a second gap between the second feeding area and the plurality of ground areas.

5. The flexible printed circuit board of claim 4, wherein the first board portion is disposed on glass,
the third board portion is disposed between a housing to which the connector is fixed and a plate, and
the plate is disposed between the third board portion and the connector.

6. The flexible printed circuit board of claim 5, wherein the housing is disposed on the glass, and
at least part of the third board portion is disposed on a round portion of the housing that is stepped from the glass and has a curved surface.

7. The flexible printed circuit board of claim 5, wherein the first width and the first gap correspond to a dielectric constant and thickness of the glass, and
the second width and the second gap correspond to the dielectric constant and thickness of the housing and the dielectric constant and thickness of the plate.

8. The flexible printed circuit board of claim 1, wherein a part of the feeding area having the second width comprises:
a first portion extending along a first direction;
a second portion extending along a second direction different from the first direction; and
a third portion formed to be curved so that the first portion and the second portion are connected,
wherein a gap between the first portion and the plurality of ground areas and a gap between the third portion and the plurality of ground areas correspond to a certain gap, and
a gap between the second portion and the plurality of ground areas is larger than the certain gap.

9. The flexible printed circuit board of claim 8, wherein the gap between the second portion and the plurality of ground areas increases as it approaches the antenna.

10. The flexible printed circuit board of claim 1, wherein the second board portion comprises a signal pinhole through which a signal pin of the connector passes,
wherein the second width is larger than a diameter of the signal pinhole.

11. An antenna assembly comprising:
an antenna positioned in a first area of glass;
a connection module which is positioned in a second area of the glass, and includes a connector; and
a flexible printed circuit board which has one surface on which a feeding area and a plurality of ground areas that are electrically separated from the feeding area are disposed,
wherein the flexible printed circuit board comprises:
a first board portion connected to the antenna;
a second board portion connected to the connector; and
a third board portion disposed between the first board portion and the second board portion,
wherein a first width of a first feeding area disposed in the first board portion is greater than a second width of a second feeding area disposed in the second board portion,
a width of one end of a third feeding area disposed in the third board portion, one end being adjacent to the first board portion, corresponds to the first width, and
a width of the other end of the third feeding area, the other end being adjacent to the second board portion, corresponds to the second width.

12. The antenna assembly of claim 11, wherein the connection module comprises:
a lower housing which is coupled on the glass, and on which the second board portion is seated; and
an upper housing which is opposite to the lower housing with respect to the board, and coupled to the lower housing,
wherein the connector is positioned between the board and the upper housing.

13. The antenna assembly of claim 11, wherein the antenna is a transparent antenna,
the first area is a transparent region, and
the second area is an opaque region.

14. The antenna assembly of claim 11,
wherein the lower housing comprises a round portion that is stepped from the glass and has a curved surface, and
at least part of the third board portion is disposed on the curved surface of the round portion.

15. The antenna assembly of claim 11, further comprising a plate which is positioned between the flexible printed circuit board and the connector, and coupled to the flexible printed circuit board,
wherein a signal pin of the connector penetrates the plate and the second board portion, and is coupled to the second board portion.
